**Europäisches Patentamt**

**European Patent Office**

**Office européen des brevets**

(19)

(11) **EP 1 001 528 A2**

(12) # EUROPEAN PATENT APPLICATION

(43) Date of publication:
**17.05.2000 Bulletin 2000/20**

(51) Int Cl.$^7$: **H03G 1/00**, H03F 3/08

(21) Application number: **99500211.0**

(22) Date of filing: **11.11.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **11.11.1998 ES 9802350**

(71) Applicant: **Telefonica, S.A.**
**28013 Madrid (ES)**

(72) Inventors:
• **Hernández Munoz, José Manuel**
**28020 MADRID (ES)**
• **González Torres, José**
**28020 MADRID (ES)**

(74) Representative: **Carpintero Lopez, Francisco**
**HERRERO & ASOCIADOS, S.L.**
**Alcalá, 21**
**28014 Madrid (ES)**

(54) **Integrated trans-impedance amplifier**

(57)     Trans-impedance amplifier integrated circuit, offering the possibility of setting gain and bandwidth, and of adding external modules for Automatic Gain Control (AGC) and output level control, the circuit being intended for amplifying the photocurrent produced by a photodetector in receivers of fibre optic communications systems, and which comprises a first trans-impedance preamplifier stage (1) having a modified cascode configuration and double feedback, which permits the gain-bandwidth product to be controlled via a terminal (5), and having at its output a terminal (6) with the received signal level reference for monitoring purposes. A second stage is a variable gain amplifier (2), with an input for external AGC, and a third stage is formed by an output buffer (3) with an input for external control of the output level.

FIG.1

## Description

## OBJECT OF THE INVENTION

The present invention refers to an integrated trans-impedance amplifier, which offers major innovations and benefits in comparison with similar devices known in the present state of the art.

In particular, the present invention concerns a low noise, broadband amplifier, in which the bandwidth and gain are adjustable, and the purpose of which is to amplify the photocurrent produced by a PIN or APD photodetector incorporated in receivers of fibre optic communications systems.

The field of application of the present invention lies in telecommunications, more specifically in that of the receivers in fibre optic communications systems, both for direct detection at 155 Mbit/s in the 2.488 Gbit/s band, and for coherent detection up to 622 Mbit/s.

## BACKGROUND TO THE INVENTION

The integrated trans-impedance amplifier of the invention, comprises an integrated circuit developed on a basis of a topology which allows the features of certain integrated circuits to be optimised, said integrated circuits having been developed with transistors of the MESFET type in production processes based on Gallium arsenide (GaAs).

The topology mentioned also provides control mechanisms for setting the gain and bandwidth of the circuit in accordance with the requirements of the system in which it is used.

The circuit developed in the present invention proves specially suitable for building the optical to electrical signal conversion stage in both direct detection systems employing Intensity Modulation Direct Detection (IM-DD), and coherent systems employing Wavelength Division Frequency Shift Keying (WD-FSK).

## BRIEF DESCRIPTION OF THE INVENTION

Other characteristics and benefits of the invention shall be more clearly indicated in the following detailed description of a preferred embodiment thereof, provided by way of an explanatory illustration not subject to limitation, reference being made therein to the attached drawings in which:

Figure 1 shows the block diagram of the integrated trans-impedance amplifier circuit, and

Figure 2 is a representation of the electrical schematic of the trans-impedance preamplifier, provided with a novel topology.

## DESCRIPTION OF A PREFERENTIAL EMBODIMENT OF THE INVENTION

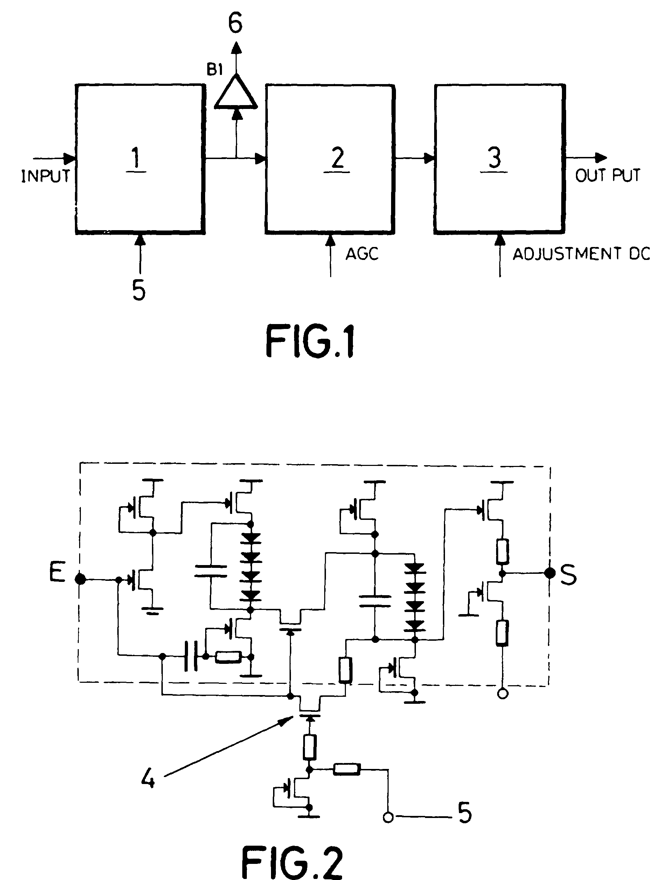

With reference to the Figures containing the attached drawings, it can be seen that Figure 1 is a representation of a block diagram of the trans-impedance amplifier circuit, in which it can be appreciated that said integrated circuit comprises three clearly differentiated stages, of which a first trans-impedance preamplifier stage (1) has a control signal (5) available for adjusting the relationship between the bandwidth and the gain. In addition, it has an output (6) for monitoring purposes which provides a received signal level reference independently of the gain control status in the intermediate controlled gain stage. It has a multi-stage configuration with double feedback, developed as an evolved cascode topology (Figure 2). With this arrangement, an adequate compromise is achieved between gain, bandwidth and noise, making this section independent of variations in power supply voltage and of production process tolerances. As a novel feature of this topology, the first feedback loop contains a transistor (4) of the MESFET type with reduced gate width (25 um or less), and biased in the linear region. This transistor replaces the Rf found in similar conventional circuits. In the preferred practical embodiment, this feature makes it possible to adjust the bandwidth between 120 MHz and 1.9 GHz, with an equivalent resistance of 8.7 k-Ohms and 1.2 k-Ohms, respectively. In the topology described, the MESFET is employed as a variable impedance. The transistor parasitic capacitances contribute only marginally to reducing the bandwidth since the Miller effect present in the first stage has been brought down to a moderate level, thereby preventing the capacitance of the photodiode that feeds the electrical signal to the input from becoming dominant, which would result in a drastic reduction in bandwidth when using the amplifier with certain types of photodiode.

The preamplifier (1) is followed with two identical buffer stages, which provide additional gain. One buffer is employed to drive the following stage, and the other facilitates the output for monitoring purposes. Their topology is extensively used in diverse conventional implementations, for which reason it has not been included in the Figures.

The second stage of the block diagram of Figure 1, is formed by a controlled gain amplifier (2), consisting of three stages with individual feedback. Each stage incorporates a MESFET transistor with 100 um gate width, which works in a resistive mode within the feedback loop. There is a fourth overall feedback loop (DC) which stabilises the operating point of the chain. This section permits a broad control range (>40 dB) to be obtained, while maintaining a flat response in the band for any point set, and a cut-off frequency above 2 GHz. It is possible to make use of an external automatic gain control (AGC) loop, increasing thereby the dynamic range of the receiver.

Following this, the third section in the block diagram is formed by the output buffer (3), the configuration of which provides feedback which facilitates a suitable shift in DC level sufficient to obtain output logic levels compatible with ECL (Emitter-Coupled Logic) technology, while simultaneously providing matching to normalised loads ($Z_1$ = 50 Ohms). The gain of this stage is low (7 dB), since its purpose is to be capable of supplying the necessary power to the load, avoiding distortion through signal compression, while ensuring a bandwidth greater than that of the preceding sections. A gain amplifier (2) can include an external DC feedback loop which permits the operating point of the circuit to be stabilised when it is necessary to ensure an exact DC level at the output.

DC coupling is employed between stages in order to avoid signal impairment when the circuit is used for occasional transmission only. To ensure an adequate margin in power supply voltages, self-biasing techniques are employed at different points in the circuit.

Figure 2 shows the electrical schematic of the trans-impedance preamplifier (1), with modified cascode topology, those parts of the structure which are conventional being enclosed within dashed lines while lying outside said lines can be seen the bandwidth gain control terminal with reference (5) and, with reference (4), the MESFET type transistor of the first feedback loop, biased in the linear region.

The integrated circuit chip of the invention incorporates decoupling means for the power supply terminals, and protective measures for inputs sensitive to ESD (Electrostatic Discharge).

With the topology developed, an integrated circuit has been achieved with characteristics that can be adjusted according to the requirements of the system in which it is used, its transfer characteristics being modelled as a function of requirements. Its most important characteristic, the trans-impedance gain, can be found from the following expression:

$$G_{TI} \text{ (dB-Ohms)} = 20.\log\{Z_O.S_{21}/(I - S_{11})\}.$$

It may be observed that the joint variation of the parameters $S_{21}$ and $S_{11}$, in accordance with a controlled mechanism, permits the desired $G_{TI}$ to be obtained.

## Claims

1. Trans-impedance amplifier integrated circuit, for broadband and low noise operation, comprising a first trans-impedance preamplifier stage (1), a second stage incorporating a variable gain amplifier (2), and a third stage with output buffer (3), electrically interconnected in a predetermined manner, which is characterised in that the said preamplifier stage (1) includes a topology which permits, by including MESFET type transistors, a control terminal (5) to be provided for setting the relationship between the bandwidth and the gain of the signal, the provision of an output terminal (6) for monitoring purposes having the received signal level reference independently of the gain control status, and also to have, in the variable gain amplifier stage (2), an input for adding an external automatic gain control (AGC) loop and, in the output buffer stage (3), an input for an external feedback loop intended for stabilising the circuit operating point, with the object of allowing direct connection of a fibre optic receiver device for the purpose of amplifying the photocurrent produced by the photodetector device as a result of converting the optical signal into an electrical signal, in both direct and coherent detection receivers.

2. Trans-impedance amplifier integrated circuit, in accordance with claim 1, which is characterised in that it includes, in the preamplifier stage (1), a multistage configuration with double feedback, based on a modified cascode topology, in which a MESFET type transistor (4) is included in the first feedback loop, having reduced gate width and being biased in the linear region, as a variable impedance, which provides control over the circuit operating parameters (gain-bandwidth product), the object being to achieve the required relationship between gain, bandwidth and noise, independently of the variations in power supply voltage and of production process tolerances.

FIG.1

FIG.2